(19) Europäisches Patentamt
European Patent Office
Office européen des brevets

(11) **EP 3 125 428 B1**

(12) **FASCICULE DE BREVET EUROPEEN**

(45) Date de publication et mention de la délivrance du brevet:
**19.08.2020 Bulletin 2020/34**

(51) Int Cl.:
**H03H 9/02** *(2006.01)*  **B60C 23/04** *(2006.01)*
**G01K 11/26** *(2006.01)*  **G06K 19/067** *(2006.01)*

(21) Numéro de dépôt: **16181785.3**

(22) Date de dépôt: **28.07.2016**

(54) **RESONATEUR A ONDES ELASTIQUES DE SURFACE SIMPLE PORT SUR SUBSTRAT A FORTE PERMITTIVITE**

ELASTISCHER OBERFLÄCHENWELLENRESONATOR IN SINGLE-PORT-AUSFÜHRUNG AUF SUBSTRAT MIT HOHER PERMITTIVITÄT

SINGLE-PORT SURFACE ELASTIC WAVE RESONATOR ON HIGH-PERMITTIVITY SUBSTRATE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.07.2015 FR 1557372**

(43) Date de publication de la demande:
**01.02.2017 Bulletin 2017/05**

(73) Titulaire: **Senseor**
**06560 Valbonne - Sophia-Antipolis (FR)**

(72) Inventeurs:
• **BALLANDRAS, Sylvain**
  **25000 BESANÇON (FR)**
• **ALZUAGA, Sébastien**
  **25620 TARCENAY (FR)**

(74) Mandataire: **Esselin, Sophie et al**
**Marks & Clerk France**
**Conseils en Propriété Industrielle**
**Immeuble Visium**
**22 avenue Aristide Briand**
**94117 Arcueil Cedex (FR)**

(56) Documents cités:
**EP-A1- 0 481 733    FR-A1- 2 864 618**
**FR-A1- 2 951 335    US-A1- 2009 230 816**

Remarques:
Le dossier contient des informations techniques présentées postérieurement au dépôt de la demande et ne figurant pas dans le présent fascicule.

**Description**

Le domaine de l'invention est celui des résonateurs simples ports à ondes élastiques pouvant notamment être utilisés dans des systèmes de mesure comprenant des dispositifs résonants à ondes élastiques interrogeables à distance et ce au travers d'une liaison sans fil radiofréquence. Ces dispositifs peuvent être utilisés notamment dans le cadre de capteurs, passifs interrogeables à distance.

De tels capteurs sont connus pour être utilisés par exemple comme capteurs de température ou de pression et comprennent généralement au moins un résonateur comportant une micro-structure déposée à la surface d'un substrat piézoélectrique. Un exemple de capteur peut typiquement comporter au moins un transducteur à peignes d'électrodes inter-digitées placés entre des réseaux réflecteurs, formant un résonateur. Les réseaux réflecteurs se comportent comme des miroirs de Bragg et il existe donc des fréquences de résonance pour lesquelles le trajet retour dans la cavité est égal à un nombre entier de longueurs d'onde acoustique $\lambda$. Les modes de résonance pour ces fréquences sont excités par le transducteur placé entre les miroirs.

Ce type de capteur peut être interrogé à distance, en connectant l'entrée du transducteur à une antenne radio-fréquence (RF). Lorsque l'antenne reçoit un signal électromagnétique, celui-ci donne naissance à des ondes sur la surface du substrat qui sont elles-mêmes reconverties en énergie électromagnétique sur l'antenne. Ainsi, le dispositif constitué d'au moins un résonateur connecté à une antenne a une réponse à la fréquence de résonance du résonateur qu'il est possible de mesurer à distance. On peut ainsi réaliser des capteurs interrogeables à distance. Et la puissance transmise au résonateur est déterminée par le recouvrement spectral entre l'impulsion émise et la fonction de transfert du transducteur.

Les documents US2009/0230816 A1 et FR2951335 A1 divulguent des résonateurs à ondes élastiques de surface selon l'état de la technique.

Le domaine de la présente invention concerne plus précisément les applications de capteurs pouvant fonctionner à des températures élevées typiquement pouvant être comprises entre 300 et 1000°C.

Des recherches ont été menées dans le cadre d'un programme de recherche d'envergure « *SAWHOT* » correspondant à l'acronyme de *« Surface Acoustic Waves wireless sensors for High Operating Temperature environment»* ou encore « *Capteurs acoustiques à ondes de surface pour applications en environnements difficiles* » et portant sur la conception de capteurs de température sans fil, interrogeables à distance, capables de fonctionner à des températures allant de - 200°C à + 650°C, et basé sur des substrats de type langasite (LGS), matériau connu pour ses bonnes propriétés de tenue en température (point de fusion aux alentours de 1470°C, pas de température de Curie, maintien des propriétés piézoélectriques jusqu'à 900°C au moins).

Dans ce cadre, le Demandeur a notamment considéré des résonateurs fabriqués sur deux coupes de LGS, l'une (la coupe dite (YX)) présentant une température d'inversion aux alentours de 300°C alors que l'autre (coupe (YX*lt*)/48,5°/26,7° dite coupe standard) se comporte de façon quasi-linéaire en termes de dérive fréquence-température sur toute la gamme de mesure (300-800°C).

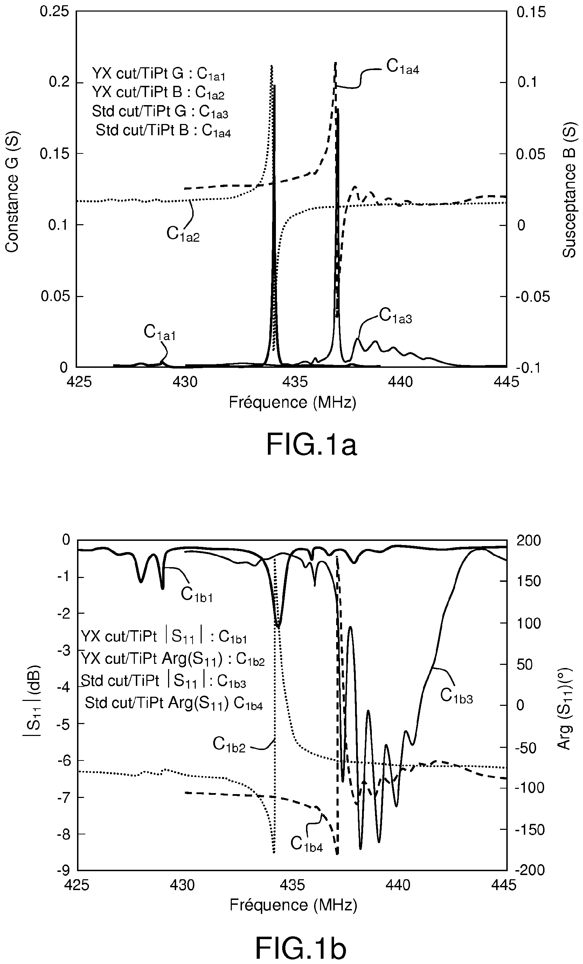

L'utilisation de ces deux coupes pour la mise au point de capteurs différentiels de température à résonateurs séparés et appairés a fait l'objet d'une demande de brevet européen CNRS/ENSMM/TU-Clausthal EP2980550. Les travaux menés dans le cadre de ce projet ont mis en évidence notamment qu'il était possible de réaliser un équilibre de la réponse des résonateurs en conductance et susceptance et donc d'obtenir des admittances équilibrées en couplage et en coefficient de qualité, comme représenté en figure 1a (courbes $C_{1a1}$ et $C_{1a3}$ : relatives aux conductances et $C_{1a2}$ et $C_{1a4}$ : relatives aux susceptances). Plus précisément, il apparaît qu'il est possible d'obtenir une optimisation donnant lieu à des réponses en admittance de même amplitude (200 mS en pic de conductance), présentant des couplages comparables (entre 0,2 et 0,3%) et des coefficients de qualité similaires (de l'ordre de 2500 à 3000) [le coefficient de couplage d'un résonateur est proportionnel à l'écart relatif entre les fréquences de résonance et d'antirésonance, le coefficient de qualité étant relatif au ratio $f_0/\Delta f$, $f_0$ étant la fréquence centrale et $\Delta f$ la largeur à mi-hauteur de la conductance (partie réelle de l'admittance) ou de la résistance (partie réelle de l'impédance), selon que l'on caractérise le résonateur sur sa résonance ou son antirésonance.

Néanmoins, si l'on observe les réponses en paramètres $S_{11}$, correspondantes (représentant le coefficient de réflexion qui reflète l'absorption d'énergie au sein du résonateur en analysant ce qui revient) comme illustré en figure 1b (courbes $C_{1b1}$ et $C_{1b3}$: relatives au paramètre I$S_{11}$I, courbes $C_{1b2}$ et $C_{1b4}$ relatives aux paramètres Arg($S_{11}$)), on se rend compte d'une part que l'amplitude du pic de réflexion est médiocre et que d'autre part le spectre est loin de présenter la pureté spectrale escomptée. Le module du paramètre $S_{11}$ présente en particulier un pic négatif (en représentation logarithmique) d'autant plus marqué que l'impédance du résonateur à la fréquence correspondante s'approche de 50 $\Omega$. Il est donc nécessaire d'approfondir les règles de conception afin d'obtenir des performances satisfaisantes en termes de coefficient de réflexion $S_{11}$.

Dans ce contexte, le Demandeur s'est orienté vers une nouvelle approche de conception de résonateurs et ce dans le cadre de la problématique des résonateurs simples ports à base de matériau à permittivité diélectrique relative élevée (typiquement supérieure à 15) tels que la langasite.

Pour ce faire, le Demandeur a établi de nouveaux critères de conception portant principalement sur le coefficient de réflexion $S_{11}$ des résonateurs compte tenu de la prédominance de ce paramètre dans la phase d'interrogation des capteurs.

Les critères retenus sont :

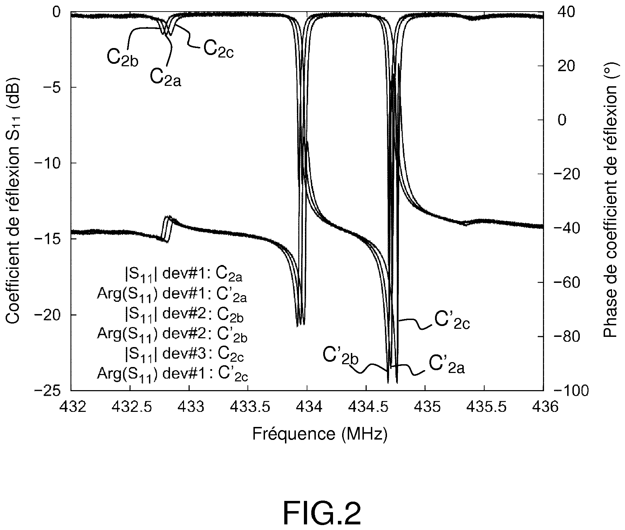

- une valeur minimum du paramètre $S_{11}$ devant être d'au moins - 10 dB, une valeur typique de -15 dB étant préconisée. A titre d'exemple, la dynamique de la réponse en réflexion d'un capteur SEAS10 de SENSeOR est supérieure en valeur absolue à cette valeur type ;
- une pureté spectrale satisfaisante, soit un pic unique coïncidant avec l'excitation/détection du mode de surface. Inévitablement des pics parasites sont mis en évidence, ceux-ci devant être rejetés au minimum de 5 dB par rapport au pic principal, cherchant typiquement à atteindre un rejet de 10 dB de ces modes pour garantir le fonctionnement du capteur sur sa gamme de température. La phase présente une rotation typique de 180° (soit de $\pi$ et jamais inférieure à 120° ou $2\pi/3$) pour garantir le fonctionnement en résonateur du capteur. Pour étayer ce propos, la figure 2 met en évidence la réponse en coefficient $S_{11}$ du capteur SEAS10 montrant des pics de plus de 15dB de dynamique mais une rotation de phase de 80° à 120° seulement. La rotation de phase rend compte de la capacité du résonateur à se comporter comme une capacité avant la résonance et comme une self inductance entre la résonance et l'antirésonance. Une rotation de phase inférieure de 80 à 120°C indique que le comportement du résonateur est limité par la prépondérance de la capacité statique au dépend des paramètres motionnels (les courbes $C_{2a}$, $C_{2b}$ et $C_{2c}$ sont relatives à des coefficients S11, les courbes $C'_{2a}$, $C'_{2b}$ et $C'_{2c}$ sont relatives aux phases). Pour un résonateur de qualité, le circuit équivalent à la résonance ou à l'antirésonance est principalement conditionné par la résistance motionnelle (en clair, le module de l'admittance ou de l'impédance est homogène à sa partie réelle). Si les pertes (résistives, de rayonnement, viscoélastiques, etc.) sont trop importantes, la partie imaginaire de l'admittance ou de l'impédance à la résonance ou à l'anti-résonance joue un rôle non négligeable et le résonateur ne peut pas exprimer le changement de comportement capacitif-selfique en plein. La partie capacitive tend alors à l'emporter et à brider l'effet de résonance.

Dans le cadre de la conception de résonateurs sur LGS performants et compte tenu de la gamme particulièrement étendue de température de travail, obtenir une réponse pure spectralement sur toute cette gamme en paramètres $S_{11}$ représente une réelle difficulté.

Le Demandeur a conclu de l'analyse des designs du programme *« SAWHOT »* que l'impédance des dispositifs correspondants ne permet pas d'obtenir une réponse spectrale monomode. En effet, avec des valeurs d'impédance de plusieurs centaines d'Ohms et malgré les efforts de réduction des pics parasites à leur minimum, les pics de réflexion correspondant à un accord d'impédance partiel à 50 $\Omega$ s'avèrent particulièrement nombreux.

De manière générale, l'obtention d'une réponse spectrale pure au sens du paramètre de réflexion $S_{11}$ impose de rapprocher autant que faire se peut soit le pic de résonance soit le pic d'antirésonance d'une impédance comparable à l'impédance de charge vue par le résonateur ou le couple de résonateur, par exemple si ceux-ci sont montés en parallèle sur une même antenne. Cette impédance de charge est souvent égale à 50 $\Omega$ mais elle peut prendre toute valeur entre 50 et 100 $\Omega$ voire plus pour des antennes de conception spécifique. Une antenne dipôle en milieu libre présentera typiquement une impédance de charge de 75 $\Omega$.

Toute situation intermédiaire au sens de l'impédance présentée par le résonateur ou le couple de résonateurs donne lieu aux types de réponses obtenues dans le cadre du programme « *SAWHOT »*.

Les présentes considérations sont vraies dans le cadre de l'utilisation de la langasite et compte tenu de ses propriétés acousto-électriques et diélectriques mais elles sont également applicables à l'ensemble des matériaux proches (LGT, LGN, etc.) et de manière plus générale de tous les matériaux habituellement exploités pour l'interrogation à distance de résonateurs.

Pour illustrer cette approche, le Demandeur a considéré que chaque résonateur était connecté indépendamment à un circuit de charge d'impédance caractéristique égale à 50 $\Omega$, cette illustration n'est en aucun cas restrictive, le principe pouvant être appliqué au cas d'une charge de 75, 100, 150 $\Omega$ et de façon générale à toute charge impédante spécifique d'une antenne radiofréquence (RF) ou de tout circuit-hôte du résonateur.

Le Demandeur a ainsi considéré l'alternative suivante : soit il est possible de forcer le pic de résonance au voisinage de 50 $\Omega$, ainsi l'anti-résonance située à plusieurs k$\Omega$ ne contribue pas de façon significative au paramètre $S_{11}$, soit il est possible d'accorder le pic d'anti-résonance à proximité de 50 $\Omega$.

Les études menées par le Demandeur ont pu mettre en évidence que des résonateurs à ondes élastiques de surface réalisés sur des substrats piézoélectriques présentant des permittivités diélectriques relatives élevées, typiquement supérieures à 15, pouvaient donner de très bonnes performances en termes de coefficient $S_{11}$ et de pureté spectrale avec des conceptions optimisées en termes d'architecture d'électrodes et ce en accordant le pic d'antirésonance à proximité de l'impédance de charge, pouvant typiquement être de 50 $\Omega$ ou plus.

C'est pourquoi, la présente invention a ainsi plus précisément pour objet un résonateur à ondes élastiques de surface comprenant un matériau piézoélectrique destiné à la propagation des ondes élastiques de surface et au moins un transducteur inséré entre une paire de réflecteurs, ledit transducteur comprenant des peignes d'électrodes interdigitées, présentant un nombre Nc d'électrodes connectées à un point chaud et une ouverture acoustique W caractérisé en ce que le matériau piézoélectrique présente une permittivité relative supérieure à 15 F.m$^{-1}$, ledit transducteur présentant un produit Nc.W/fa supérieur à 100 $\mu$m.MHz$^{-1}$ avec fa la fréquence d'antirésonance dudit résonateur.

De manière connue, l'ouverture acoustique d'un transducteur correspond à la longueur de recouvrement entre deux doigts de peignes de polarité différente.

De manière connue la permittivité relative $\varepsilon_r$ est définie par :

$$\varepsilon = \varepsilon_{0 \times} \varepsilon_r$$

avec $\varepsilon$ : la permittivité et $\varepsilon_0$ : la permittivité d'un milieu de référence (le vide) et égale à 8,854187 x 10$^{-12}$ F. m$^{-1}$.

Selon des variantes de l'invention, le matériau piézoélectrique est de la langasite, le produit Nc.W/fa pouvant être compris entre 100 et 1000 $\mu$m.MHz$^{-1}$.

Selon des variantes de l'invention, le matériau piézoélectrique est de l'oxyde de zinc, le produit Nc.W/fa pouvant être compris entre 400 et 2000 $\mu$m.MHz$^{-1}$.

Selon des variantes de l'invention, le matériau piézoélectrique est du quartz, le produit Nc.W/fa pouvant être compris entre 2400 et 3600 $\mu$m.MHz$^{-1}$.

Selon des variantes de l'invention, le matériau piézoélectrique est du nitrure d'aluminium AIN, le produit Nc.W/fa pouvant être compris entre 400 et 2000 $\mu$m.MHz$^{-1}$.

Selon des variantes de l'invention, le matériau piézoélectrique est du tantalate de lithium LiTaO$_3$, le produit Nc.W/fa pouvant être compris entre 100 et 1000 $\mu$m.MHz$^{-1}$.

Selon des variantes de l'invention, le matériau piézoélectrique est du niobate de lithium, le produit Nc.W/fa pouvant être compris entre 1400 et 3000 $\mu$m.MHz$^{-1}$.

Les gammes de valeurs Nc.W/fa données ci-dessus sont notamment intéressantes pour des applications dans des bandes de fréquences d'interrogation de circuits comprenant les résonateurs, de l'ordre de 400 MHz à 450 MHz, permettant notamment que ledit transducteur soit accordé avec une impédance de charge comprise entre 50 et 100 Ohms à 434 MHz.

Selon des variantes de l'invention, les électrodes sont à base de platine.

Selon des variantes de l'invention, les électrodes sont à base de platine ou de titane ou de lanthane, ou un mélange de certains des métaux précités. Pour les applications à hautes températures (au-delà de 300°C), le couple titane (5 à 30 nm)/ platine (100 à 250 nm) ou tantale/platine dans les mêmes proportions constitue une solution éprouvée. D'autres matériaux peuvent cependant être considérés : zirconium, molybdène, tungstène, etc.

Pour les températures classiques (inférieures à 300°C), il est intéressant d'employer l'aluminium, l'aluminium allié cuivre, titane ou silicium, le nickel, le chrome, etc.

Selon des variantes de l'invention, le résonateur comprend une couche de passivation pouvant être une couche d'alumine ou de nitrure de silicium ou d'oxyde de silicium ou de nitrure d'aluminium.

L'invention a aussi pour objet un circuit comprenant au moins une impédance de charge et au moins un résonateur selon l'invention et présentant une réponse électrique traduite par un pic de coefficient de réflexion $S_{11}$ en fréquence caractérisée par une valeur minimum du paramètre $S_{11}$ au moins inférieure à - 10 dB d'au moins 10 dB, le pic d'antirésonance dudit résonateur étant adapté à l'impédance de ladite charge.

L'invention a encore pour objet un capteur passif interrogeable à distance comprenant un circuit selon l'invention, il peut par exemple s'agir d'un capteur de température passif interrogeable à distance selon l'invention.

L'invention a encore pour objet un circuit comprenant au moins deux résonateurs selon l'invention, connectés en série. Les deux résonateurs peuvent être connectés à une antenne.

L'invention a aussi pour objet un système d'interrogation d'un circuit ou d'un capteur selon l'invention caractérisé en ce qu'il comprend des moyens d'interrogation fonctionnant dans une bande de fréquences pouvant être situées entre 400 MHz et 450 MHz ou dans une bande de fréquences pouvant être situées entre 900 MHz et 950 MHz (bande ISM anglo-saxone à 915 MHz) ou dans une bande de fréquences pouvant être situées entre 850 MHz et 900 MHz (bande fonctionnant à 868 MHz).

L'invention sera mieux comprise et d'autres avantages apparaîtront à la lecture de la description qui va suivre donnée à titre non limitatif et grâce aux figures annexées parmi lesquelles :

- les figures 1a et 1b illustrent respectivement les réponses en admittance en fonction de la fréquence et les réponses en paramètres $S_{11}$ en fonction de la fréquence pour des dispositifs développés dans le cadre du programme *SAWHOT;*

- la figure 2 illustre la réponse en coefficient $S_{11}$ du capteur SEAS10 montrant des pics de plus de 15dB de dynamique mais une rotation de phase de 80° à 120° seulement
- la figure 3a illustre un résonateur à ondes élastiques simple port utilisé dans la présente invention et la figure 3b illustre le circuit équivalent d'un résonateur à ondes élastiques à simple port ;
- les figures 4a à 4c illustrent l'analyse de la réponse de résonateurs branchés en série et en parallèle pour une conception optimisée à la résonance - $C_0$=0,73pF : la figure 4a est relative à l'impédance (module), maximisée pour les résonateurs branchés en série ; la figure 4b est relative à un zoom sur l'accord à 50 Ω, les résonateurs branchés en série présentent une impédance toujours supérieure à 50 Ω ; la figure 4c est relative à la réponse en module du coefficient de réflexion $S_{11}$ ;
- les figures 5a et 5b illustrent l'analyse de la réponse de résonateurs branchés en série et en parallèle pour une conception optimisée à l'anti-résonance - $C_0$=73pF : la figure 5a est relative à l'Impédance (module), minimisée par les résonateurs branchés en parallèle ; la figure 5b est relative à la réponse en module du coefficient de réflexion $S_{11}$ ;
- Les figures 6a et 6b caractérisent des couplages électromécaniques de chaque contribution pour les deux configurations de connexion : la figure 6a est relative à des résonateurs en parallèle : fonctionnement sur la résonance ;
- Les figures 7a et 7b illustrent respectivement la façon dont peuvent être agencés les résonateurs connectés en parallèle lorsque ceux-ci fonctionnent (sont interrogés) sur la résonance (configuration dite « classique ») et la connexion, pour laquelle les résonateurs sont connectés en série.

Le Demandeur décrit ci-après plus en détails, le raisonnement qu'il a mené pour conduire aux conditions de réalisation et d'adaptation de résonateurs à ondes élastiques de surface selon la présente invention.

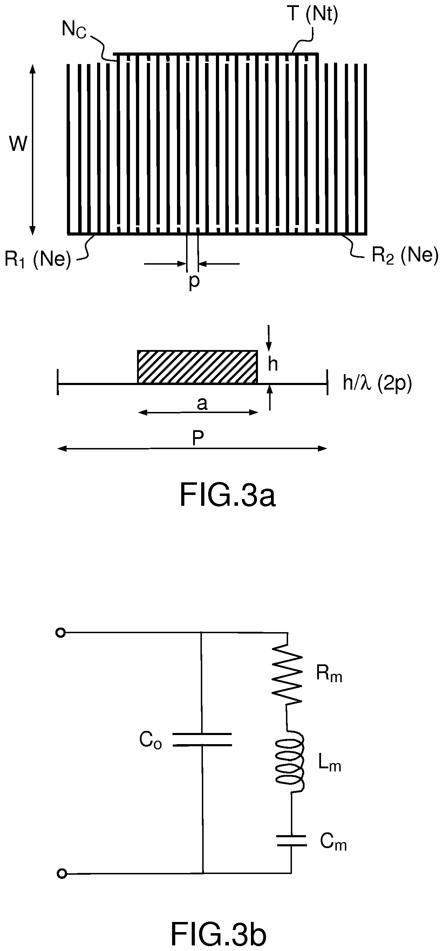

Le résonateur simple port de l'invention peut comprendre de manière classique, deux peignes de métallisations interdigitées présentant des doigts de largeur a, de période p (définissant un ratio dit de métallisation a/p égal à la largeur de l'électrode sur le pas de répétition des électrodes) constituant un transducteur à ondes élastiques de surface T, placé entre deux réseaux réflecteurs métallisés R1 et R2. Les peignes sont connectés de manière à présenter des polarités différentes. L'ouverture W est définie par la longueur de recouvrement entre deux doigts de polarité différente. Le nombre d'électrodes du transducteur connectées à un point chaud est égal à Nc. La figure 3a illustre ainsi un résonateur simple port avec une ouverture W pouvant typiquement être d'environ 40 λ, mettant en évidence le transducteur T entre deux miroirs R1 et R2 présentant Ne électrodes, le transducteur présentant un nombre total Nt électrodes, l'épaisseur relative des électrodes étant égale à h/λ = 2p.

Dans le cas d'un capteur passif interrogeable à distance, le transducteur est connecté à une antenne. Ainsi l'ensemble résonateur/ antenne est notamment étudié dans le cadre de la présente invention, au niveau des impédances de l'antenne et de celle du résonateur.

Il est rappelé que les résonateurs à ondes élastiques à simple port sont assimilables à un circuit équivalent présentant une branche dite motionnelle comptant en série une self-inductance $L_m$, une capacité $C_m$ et une résistance $R_m$ toutes dites motionelles et en parallèle à cette branche une capacité dite statique $C_0$ comme représenté en figure 3b. Ce circuit équivalent est connu de l'homme de l'art sous l'appellation « Butterworth-VanDyke ».

Le circuit peut être assorti d'une résistance en amont de ces deux branches dites résistance série ou de contact rendant compte des pertes ohmiques dues à la connexion du résonateur et une résistance de fuite en parallèle de la capacité statique rendant compte des fuites de courant dans le matériau si celui-ci n'est pas parfaitement diélectrique (ce qui peut être le cas lors d'inclusions ioniques au sein de la maille cristalline). Un tel circuit équivalent est notamment décrit et utilisé dans la demande de brevet VECTRON-SENGENUITY E2287584A1 - WO2011/020888A1 qui concerne des critères de conception fondés sur les valeurs de composants motionnels équivalents.

Le Demandeur décrit ci-après plus en détails, le raisonnement qu'il a mené pour conduire aux conditions de réalisation et d'adaptation de résonateurs à ondes élastiques de surface selon la présente invention.

L'analyse qui a été réalisée et qui est présentée dans la présente demande de brevet consiste à calculer l'admittance du circuit constitué par la réponse d'un résonateur à ondes de surface (ROS) simple port et à évaluer la valeur de l'impédance à l'antirésonance pour tirer des lois de « design » génériques.

En supposant la résistance $R_m$ nulle dans une étape de dimensionnement approximative, on montre que les pulsations de résonance et d'antirésonance sont données par les relations suivantes :

$$\omega_r = (1/ L_m C_m)^{\frac{1}{2}} \quad \text{et} \quad \omega_a = [(C_0 + C_m)/ L_m C_m C_0]^{\frac{1}{2}} \qquad (1)$$

Si l'on sait déterminer la valeur de la capacité statique $C_0$, on a alors accès aux valeurs de $C_m$ et de $L_m$ en utilisant les relations suivantes :

$$C_m = C_0 \left( \frac{\omega_a^2 - \omega_r^2}{\omega_r^2} \right) \approx C_0 k_s^2 \qquad (2)$$

avec $ks^2$ le couplage électromécanique donné par l'écart relatif des fréquences de résonances et d'antirésonance, soit en première approximation 2(fa- fr)/fr, comme décrit dans l'article de Royer, E. Dieulesaint, « Ondes acoustiques dans les solides », tome 1, 1998, Masson Ed.

L'expression de l'admittance du circuit équivalent est telle que :

$$Y(\omega) = jC_0\omega + \frac{jC_m\omega}{(1 - L_m C_m \omega^2) + jR_m C_m \omega} \qquad (3)$$

La résistance $R_m$ est donnée par l'inverse de la partie réelle de l'admittance à la résonance :

$$Y(\omega_r) = 1/R_m + j\, C_0\, \omega_r$$

L'amortissement $A$ est donné par le rapport : $R_m/2L_m$, ce qui permet d'estimer le coefficient de qualité $Q$ du résonateur tel que :

$Q = \omega_r/2A$ soit encore $Q = \omega_r L_m / R_m$, ce qui permet d'estimer la valeur de la résistance à partir du coefficient de qualité du résonateur, et ainsi caractériser dans les grandes lignes tout résonateur à simple port électrique (on mesure facilement le couplage si la résonance est bien définie spectralement par l'écart entre fréquences de résonance et d'antirésonance, une mesure basse fréquence fournie elle la valeur de capacité statique). Il est précisé que le coefficient Q correspond au coefficient de qualité de la résonance selon la définition précédemment établie. Il est utilisé par la suite pour simplifier l'écriture mais sa définition reste conforme à celle donnée dans les lignes précédentes.

En réécrivant l'admittance à partir de l'équation (3) on obtient (4) :

$$Y(\omega) = \frac{jC_0(1 - L_m C_m \omega^2) + jC_m\omega - R_m C_m C_0 \omega^2}{(1 - L_m C_m \omega^2) + jR_m C_m \omega} \qquad (4)$$

On cherche à rationnaliser autant que faire se peut en utilisant les relations (1), et l'on obtient :

$$Y(\omega) = C_0 \frac{j\omega L_m(\omega_a^2 - \omega^2) - R_m \omega^2}{L_m(\omega_r^2 - \omega^2) + jR_m\omega} \qquad (5)$$

L'admittance peut encore être exprimée par l'équation suivante :

$$Y(\omega) = C_0 \frac{j\omega Q(\omega_a^2 - \omega^2) - \omega^2 \omega_r}{Q(\omega_r^2 - \omega^2) + j\omega\omega_r} \qquad (6)$$

dans laquelle tous les éléments de la branche motionnelle ont disparu au profit de trois paramètres mesurables objectivement, soit les pulsations de résonance et d'antirésonance et le coefficient de qualité à la résonance, spécifiques de la contribution acoustique et la capacité statique.

On exprime à partir de l'équation (6) l'impédance, et l'on obtient l'équation (7) :

$$Z(\omega) = \left( \frac{1}{jC_0\omega} \right) \frac{Q(\omega_r^2 - \omega^2) + j\omega\omega_r}{Q(\omega_a^2 - \omega^2) + j\omega\omega_r} \qquad (7)$$

Une fois cette expression établie, il est possible d'exprimer l'impédance à la résonance et à l'antirésonance :

$$Z(\omega_r) = \left(\frac{1}{C_0\omega_r}\right)\frac{1}{Q\,\frac{\omega_a^2 - \omega_r^2}{\omega_r^2} + j} \rightarrow Z(\omega_r) = \left(\frac{1}{C_0\omega_r}\right)\frac{1}{Qk_s^2 + j} \rightarrow$$

$$Y(\omega_r) = (Qk_s^2 + j)\,C_0\omega_r \quad (8)$$

$$Z(\omega_a) = -\frac{1}{C_0\omega_a}\left(Q\,\frac{(\omega_r^2 - \omega_a^2)}{\omega_a\omega_r} + j\right) \rightarrow$$

$$Z(\omega_a) = \left(\frac{1}{C_0\omega_r}\right)\left(Q\,\frac{\omega_a^2 - \omega_r^2}{\omega_a^2} + j\right) \rightarrow Z(\omega_a) \cong \frac{Qk_s^2 + j}{C_0\omega_r} \quad (9)$$

Dans les deux cas, le Demandeur a cherché à estimer les valeurs de $C_0$ pour un module de l'impédance égal à 50 $\Omega$ (ou de l'admittance à 20 mS) afin de déterminer la structure du transducteur.

Dans le cas de la résonance et de l'anti-résonance respectivement, il vient :

$$|Y(\omega_r)| = C_0\omega_r\sqrt{(Q^2 k_s^4 + 1)} \text{ et } |Z(\omega_a)| \cong \frac{\sqrt{Q^2 k_s^4 + 1}}{C_0\omega_r} \qquad (10)$$

Dans les deux cas, on note que si $Q.k_s^2$ est très supérieur à 1, les expressions (10) peuvent être simplifiées comme suit :

$$|Y(\omega_r)| = C_0\omega_r Q k_s^2 = \frac{1}{R_m} \rightarrow |Z(\omega_r)| = R_m \text{ et } |Z(\omega_a)| \cong \frac{Q k_s^2}{C_0\omega_r} \qquad (11)$$

On définit également l'équation suivante (MORGAN, David. Surface acoustic wave filters: With applications to electronic communications and signal processing. Academic Press, 2010.) :

$$Y_{11}(\omega) = Y_T(\omega) = G_a(\omega) + j(B_a(\omega) + \omega C_0) \qquad (12)$$

où $G_a$ est la conductance acoustique, $B_a$ est la susceptance et $C_T$ est la capacité du transducteur.

La partie imaginaire de l'admittance est naturellement combinée avec la contribution de la capacité du transducteur, qui est définie par une contribution électrique dominante.

Ses valeurs sont données par les équations :

$$G_a(\omega) \approx G_a(\omega_0)\left|\frac{\sin(X)}{X}\right|^2 \qquad (13)$$

$$B_a(\omega) \approx G_a(\omega_0)\frac{\sin(2X) - 2x}{2X^2} \qquad (14)$$

$$C_0 = NcW\varepsilon_\infty \qquad (15)$$

Où $G_a(\omega_0) = 2.87\omega_0\varepsilon_\infty\,W N_c^2 \Delta\vartheta/\vartheta$ et $\varepsilon_\infty = \sqrt{\varepsilon_{11}\varepsilon_{33} - \varepsilon_{13}^2}$ (pour le quartz, $\varepsilon_\infty = {\sim}5.5\varepsilon_0$).

Le Demandeur a considéré dans un premier temps la forme suivante compte tenu de sa simplicité et de sa fidélité vis-à-vis de la forme complète pour un transducteur synchrone fonctionnant à la condition de Bragg :

$$C_0 = N_c W \varepsilon_\infty \ avec \ \varepsilon_\infty = \varepsilon_0 + \sqrt{\varepsilon_{11}\varepsilon_{33} - \varepsilon_{13}^2} \qquad (16)$$

et les cas suivants pour les valeurs de $\varepsilon_\infty$, de Q et de $k_s^2$ telles que données dans le tableau suivant :

Tableau 1: Évolution des capacités statiques en fonction des différents matériaux exploitables, pour des hypothèses de coefficients de qualité et de couplage données à 434 MHz

| Matériau | Q à 434 MHz | $k_s^2(\%)$ | $\varepsilon_\infty$ (pf/m) | $C_0$rés(pF) | $C_0$antirés(pF) |
|---|---|---|---|---|---|
| LGS (coupe YX) | 1000 | 0,35 | $32,5\varepsilon_0$ = 287 | 2,09 | 25,7 |
| LiTaO$_3$ (YXwt)/- 90°/ 112° | 1000 | 1 | $42,7\varepsilon_0$ = 377,5 | 0,734 | 73,4 |
| LiNbO$_3$ (coupe YZ) | 1000 | 5 | $35,6\varepsilon_0$ = 315 | 0,147 | 367 |

D'expérience, le Demandeur a considéré que le coefficient de qualité dépend principalement du type de métallisation et de la nature du substrat. En pratique, le fait de travailler à la résonance ou à l'antirésonance a un impact sur le coefficient de qualité effectif du dispositif. Expérimentalement, on obtient des valeurs de Q sensiblement plus élevées à l'antirésonance qu'à la résonance (le coefficient Q à l'anti-résonance est alors défini comme le maximum de résistance divisé par la largeur à mi-hauteur du pic d'anti-résonance en considérant une ligne de référence à 0 Ohms). Il est rappelé toutefois que le coefficient Q utilisé dans les relations est donné par la relation Q = $\omega_r$ L$_m$ / R$_m$, soit le coefficient de qualité Q défini à la résonance.

En particulier, les composants fonctionnant sur le point de résonance (c'est-à-dire accordés sur 50 $\Omega$ à la résonance) dont le coefficient $\varepsilon_\infty$ s'avère supérieur à une valeur de l'ordre de 15 se révèlent nettement plus sensibles à la résistance série que ceux dont le même coefficient est inférieur ou égale à cette valeur.

Par ailleurs, le Tableau 1 montre que plus le couplage est élevé, plus la capacité statique à la résonance est petite (très inférieure au pF).

On peut alors comprendre aisément qu'un dispositif fonctionnant à la résonance soit beaucoup plus sensible aux éléments capacitifs parasites qu'un résonateur exploitant l'antirésonance.

C'est pourquoi, le Demandeur propose de privilégier l'antirésonance à la résonance pour minimiser la sensibilité à la résistance série et l'impact des capacités parasites sur le dispositif fonctionnant à la résonance.

Le Tableau 2 ci-après récapitule des exemples de valeurs de capacité statique et de produit N$_c$W à la résonance et à l'antirésonance permettant de concevoir des dispositifs beaucoup moins sensibles aux effets de capacités parasites avec des matériaux piézoélectriques de permittivité relative élevées, à l'antirésonance.

Tableau 2: Produits N$_c$W types à la résonance et à l'antirésonance pour différents matériaux, pour des hypothèses de coefficients de qualité et de couplage données à 434 MHz

| Matériau | $\varepsilon_\infty$ (pf/m) | $C_0$rés(pF) | $C_0$antirés(pF) | NcWres(mm) | NcW antires (m) |
|---|---|---|---|---|---|
| LGS (coupe YX) | $32,5\varepsilon_0$ = 287 | 2,09 | 25,7 | 7,3 | 0,089 |
| LiTaO$_3$ (coupe YXwt)/- 90°/112° | $42,7\varepsilon_0$ = 377,5 | 0,734 | 73,4 | 1,94 | 0,194 |
| LiNbO$_3$ (coupe YZ) | $35,6\varepsilon_0$ = 315 | 0,147 | 367 | 0,467 | 1,16 |

On peut montrer la pertinence de ces calculs par l'expérience : un résonateur sur langasite d'orientation cristalline (YX/t)/48,5°/26,7°, définie selon le standard IEEE Std-176 sur la piézoélectricité, a été réalisé pour présenter une impédance de 90 Ohms à l'antirésonance à 455 MHz.

L'ouverture acoustique a été fixée à 700 $\mu$m et le nombre de doigts au point chaud à 350. On trouve 233 pf.m$^{-1}$ pour $\varepsilon_\infty$ soit un C$_0$ de 57,1 pF selon la formule (15). Le calcul exact pour cette configuration donne un C$_0$ de 54,2 pF. Avec un Q à la résonance de 900, on retrouve des paramètres conformes aux prévisions et qui démontrent l'efficacité du processus d'optimisation.

Le Demandeur a également comparé des résultats de conception de résonateurs fonctionnant à la résonance et à l'antirésonance à des fréquences voisines, en l'occurrence 433 MHz, visant toujours une impédance de charge de 50 Ohms et ayant recours à la coupe (YX/*t*)/48,5°/26,7°. Dans le cas d'un fonctionnement sur la résonance, il a déterminé le nombre d'électrodes du transducteur au point chaud à 25 pour une ouverture de 160 $\mu$m ($N_cW$ = 4 mm) et une métallisation de 155 nm de platine. Pour le fonctionnement sur l'antirésonance, on conserve cette même épaisseur de métallisation mais l'ouverture acoustique passe à 900 $\mu$m et le nombre de doigts au point chaud dans le transducteur à 350 ($N_cW$ = 315 mm). Le calcul de la réponse du résonateur est effectué selon la méthode de la matrice mixte. Entre autres paramètres initiaux de calcul, il est indiqué une permittivité relative pour cette configuration égale à 28,93, soit une valeur de $\varepsilon_\infty$ de 265 pF/m environ, avec une vitesse de l'ordre de 2600 m.s$^{-1}$ (tenant compte de l'effet de masse de la métallisation).

Pour le résonateur optimisé sur la résonance, l'écart entre fréquences de résonance et d'antirésonance indique un couplage électromécanique de 1,4‰ selon la formule (2) et une capacité statique de 0,916 pF. Pour le résonateur optimisé sur l'anti-résonance, ces caractéristiques passent à plus de 4,1‰ et 50,3 pF respectivement.

En conclusion, le Demandeur a montré que pour garantir la pureté spectrale d'un résonateur seul, il faut que l'impédance à la résonance ou l'anti-résonance soit la plus proche possible de celle du circuit de charge, en l'occurrence de l'antenne pour une application de capteur interrogeable à distance.

Pour une première passe de conception, le Demandeur a considéré une impédance de charge de 50 $\Omega$ mais l'expérience montre que le design doit être circonstancié au cas particulier de l'application. Simuler l'évolution de l'impédance du circuit de charge en fonction de la température dans le milieu d'implantation serait la meilleure démarche de conception envisageable, néanmoins une conception archétypique pour des milieux ouverts ou à environnements confinés métalliques ou non semble une démarche robuste pour proposer des capteurs « universels ».

En particulier, l'évolution des impédances de l'antenne dipôle et du résonateur, respectivement comprises entre 75 et 100 $\Omega$ pour la première et proche de 50 $\Omega$ pour le second à température ambiante vers une valeur identique à température de travail (par exemple 600°C) explique pourquoi le bilan énergétique de l'interrogation sans fil s'améliore avec la température.

A titre de comparaison, la permittivité diélectrique relative des ondes de Rayleigh sur LGS varie entre 20 et 30 contre 5 à 6 pour le quartz, ce qui augmente considérablement l'impédance à la résonance pour une configuration donnée. Ce facteur 5 se retrouve sur la taille des transducteurs pour optimiser un transducteur fonctionnant à la résonance. La réduction de la dimension du transducteur à quelques dizaines de longueurs d'onde et une ouverture inférieure à la vingtaine de longueurs d'ondes pour travailler à la condition de résonance avec des ondes de Rayleigh sur LGS induit une sensibilité accrue aux éléments capacitifs parasites d'autant que le couplage ne dépasse pas les 0,1% dans ce type de configuration. L'optimisation d'un tel résonateur (fonctionnant sur la résonance) nécessite donc l'élimination de toute source de capacité parasite pour le mode « résonance ». Ce mode impose un nombre d'électrodes et une ouverture acoustique réduits par rapport aux solutions sur quartz qui limitent de façon factuelle le couplage électromécanique à moins d'un pour mille.

Si l'encombrement de la puce correspondante est optimal (30 à 40% de gain en taille par rapport au même capteur sur quartz), il demeure des défauts fonctionnels.

L'utilisation d'un résonateur en mode « anti-résonance » comme proposé dans la présente demande de brevet impose quant à lui le recours à des transducteurs à ouverture et nombre d'électrodes maximisés par rapport aux solutions sur quartz. On perd donc l'aspect « compacité améliorée » apportée par la vitesse de phase des ondes de surface sur ce matériau (de 10 à 20% plus faible que celles sur quartz) mais on maintient en retour des couplages électromécaniques en ligne avec les capacités du matériau (70 à 80% du potentiel accessible, contre moins de 40% pour la solution « résonance »). Par voie de conséquence, la capacité statique est plus grande que pour la solution « résonance » et s'avère de fait nettement moins sensible aux pollutions parasites que cette dernière.

Par ailleurs, Le Demandeur a observé que des métallisations en Ti ou en Ta/Pt sont particulièrement bien adaptées à la réalisation de ces résonateurs, permettant bien d'obtenir des coefficients de qualité plus élevés pour l'anti-résonance que pour la résonance. En pratique, à 434 MHz et les fréquences environnantes, une épaisseur minimum de 100 nm de Pt peut être considérée pour optimiser le fonctionnement du transducteur et des miroirs et 150 nm est une valeur type.

Dans le cas des applications à hautes températures, le gain en coefficient de qualité offert par l'approche « anti-résonance » peut atteindre un facteur 2 à 3. Ce gain constitue un élément extrêmement différenciant pour les capteurs proposés par le Demandeur compte tenu de la réduction de ce facteur de mérite avec la température, potentiellement d'un coefficient 2 à 3 pour une excursion de 600°C par exemple (de l'ambiante à 650°C). La langasite LGS est par ailleurs connue pour ses pertes de conductivité particulièrement lorsque croît la température. Il est donc nécessaire de ne pas introduire de sources de dysfonctionnement liées à un défaut de conception d'un capteur fondé sur ce matériau et ses variantes (LGT, LGN) et de garantir autant que faire se peut l'accord d'impédance sur toute la gamme de variation de température

Le Demandeur a étudié l'impact de la connexion de résonateurs sur la réponse électrique résultante.

Pour des résonateurs associés pour réaliser un capteur différentiel interrogeable à distance, il est généralement convenu que ceux-ci soient connectés en parallèle. Il n'y a pas d'impossibilité physique à connecter ces dipôles d'une autre manière (en série, en pont, etc.) mais l'homme de l'art considère, dans l'état des connaissances et des pratiques, que la mise en série de deux résonateurs pour l'application visée ne produit pas la réponse escomptée et ne peut pas être exploitée pratiquement.

Le Demandeur a démontré qu'il est possible de vaincre ce préjugé grâce à l'optimisation de résonateurs fonctionnant sur l'anti-résonance.

En effet, en supposant deux résonateurs $R^{(1)}$ et $R^{(2)}$ optimisés pour fonctionner à la résonance, on montre que leur admittance revient à effectuer la somme des admittances respectives de chaque résonateur. En considérant la forme normalisée de cette dernière, on obtient :

$$Y(\omega) = C_0^{(1)} \frac{j\omega Q^{(1)}\left(\omega_a^{(1)2}-\omega^2\right)-\omega^2\omega_r^{(1)}}{Q^{(1)}\left(\omega_r^{(1)2}-\omega^2\right)+j\omega\omega_r^{(1)}} + C_0^{(2)} \frac{j\omega Q^{(2)}\left(\omega_a^{(2)2}-\omega^2\right)-\omega^2\omega_r^{(2)}}{Q^{(2)}\left(\omega_r^{(2)2}-\omega^2\right)+j\omega\omega_r^{(2)}} \quad (17)$$

On suppose que les capacités statiques et coefficients de qualité des deux résonateurs sont identiques afin de simplifier les équations. Il vient alors :

$$Y(\omega) = jC_0\omega\left(\frac{\left(\omega_a^{(1)2}-\omega^2\right)+j\omega\Delta\omega_r^{(1)}}{\left(\omega_r^{(1)2}-\omega^2\right)+j\omega\Delta\omega_r^{(1)}} + \frac{\left(\omega_a^{(2)2}-\omega^2\right)+j\omega\Delta\omega_r^{(2)}}{\left(\omega_r^{(2)2}-\omega^2\right)+j\omega\Delta\omega_r^{(2)}}\right) \quad (18)$$

avec ; $Q=\omega_r/\Delta\omega \rightarrow \omega_r^2/Q = \Delta\omega\ \omega_r^2/\omega_r = \Delta\omega\ \omega_r$.

A la résonance $\omega_r^{(1)}$, le circuit équivalent s'écrit :

$$Y\left(\omega_r^{(1)}\right) = jC_0\omega_r^{(1)}\left(\frac{\left(\omega_a^{(1)2}-\omega_r^{(1)2}\right)}{j\omega_r^{(1)}\Delta\omega_r^{(1)}} + 1 + \frac{\left(\omega_a^{(2)2}-\omega_r^{(1)2}\right)+j\omega_r^{(1)}\Delta\omega_r^{(2)}}{\left(\omega_r^{(2)2}-\omega_r^{(1)2}\right)+j\omega_r^{(1)}\Delta\omega_r^{(2)}}\right) \quad (19)$$

Les termes différences de fréquence de résonance et d'antirésonance sont négligeables pour le résonateur $R^{(2)}$, ce qui permet d'écrire la forme simplifiée suivante :

$$Y\left(\omega_r^{(1)}\right) \simeq C_0 \frac{\omega_r^{(1)}}{\Delta\omega_r^{(1)}}\omega_r^{(1)}\frac{\left(\omega_a^{(1)2}-\omega_r^{(1)2}\right)}{\omega_r^{(1)2}} + 2jC_0\omega_r^{(1)} = C_0\omega_r^{(1)}Qk_s^2 + 2jC_0\omega_r^{(1)} \quad (20)$$

où l'on reconnaît $1/R_m$ conformément à l'équation(11).

La mise en parallèle des deux résonateurs fait voir à chacun d'eux une capacité statique double de celle lui étant naturellement associée. Ceci est bien connu de l'homme de l'art.

En connectant les résonateurs en série, le Demandeur propose de résoudre le problème en impédance pour tirer parti de la simple somme des termes associés à chaque résonateur.

il vient ainsi :

$$Z(\omega) = \frac{1}{jC_0\omega}\left(\frac{Q\left(\omega_r^{(1)2}-\omega^2\right)+j\omega\omega_r^{(1)}}{Q\left(\omega_a^{(1)2}-\omega^2\right)+j\omega\omega_r^{(1)}} + \frac{Q\left(\omega_r^{(1)2}-\omega^2\right)+j\omega\omega_r^{(1)}}{Q\left(\omega_a^{(1)2}-\omega^2\right)+j\omega\omega_r^{(1)}}\right) \quad (21)$$

En se plaçant à l'anti-résonance du résonateur $R^{(1)}$ : on obtient la forme suivante de l'impédance en appliquant les mêmes mécanismes que pour passer des équations (18) à (20) :

$$Z\left(\omega_a^{(1)}\right) \simeq \frac{1}{jC_0\omega_a^{(1)}}\left(\frac{Q\left(\omega_r^{(1)2}-\omega_a^{(1)2}\right)}{j\omega_a^{(1)}\omega_r^{(1)}}+2\right) \simeq \frac{Qk_s^2}{C_0\omega_r^{(1)}}+\frac{2}{jC_0\omega_a^{(1)}} \qquad (22)$$

Ce résultat montre que le résonateur $R^{(1)}$ voit une capacité parallèle divisée par 2 à l'anti-résonance.

Bien qu'accessible à l'homme de l'art, le calcul du circuit équivalent d'une association de résonateurs en série ou en parallèle étant trivial, ce résultat n'a jamais été exploité compte tenu de l'opinion établie qu'il n'est pas possible de faire fonctionner deux résonateurs en série pour leur interrogation sans fil.

La principale différence entre les deux cas traités tient à la valeur maximum d'impédance que peuvent présenter les résonateurs fonctionnant à la résonance ou à l'anti-résonance. Dans le premier cas, le résonateur présente une impédance de 50 $\Omega$ à la résonance mais celle-ci atteint des valeurs notablement supérieures à l'anti-résonance.

En prenant l'application numérique suivante avec les paramètres suivants: un coefficient de qualité à la résonance Q de 10000 et un coefficient de couplage égal à 0,1%, le produit $Q.k_s^2$ vaut 10.

Pour une fréquence de résonance de 434 MHz, la capacité statique à la résonance vaut 0,73 pF pour une impédance de 50 $\Omega$ imposée pour cette fréquence.

L'impédance à l'anti-résonance atteint alors une valeur de 5 k$\Omega$ puisque les deux conditions sont séparées d'un facteur $Q^2.k_s^4$.

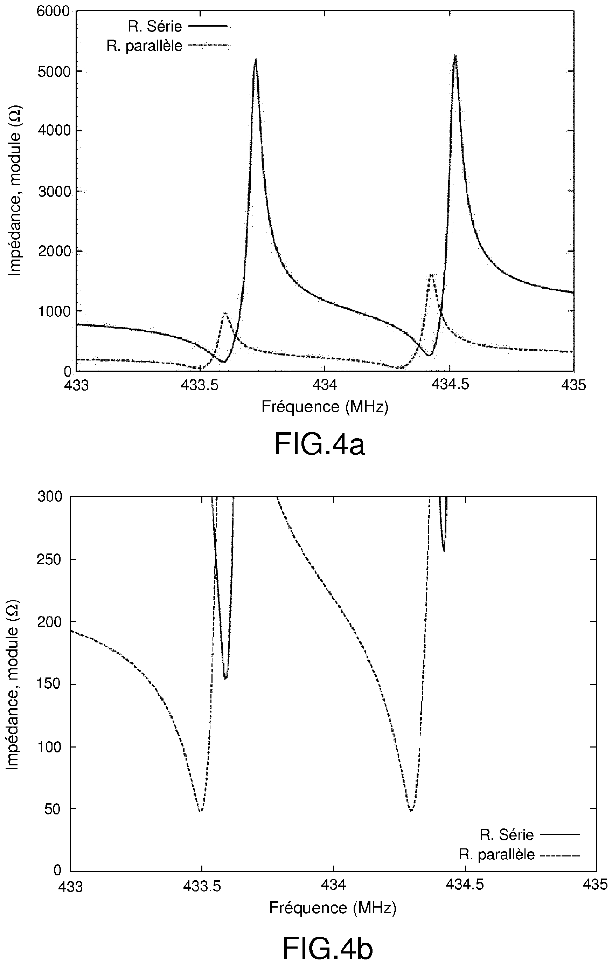

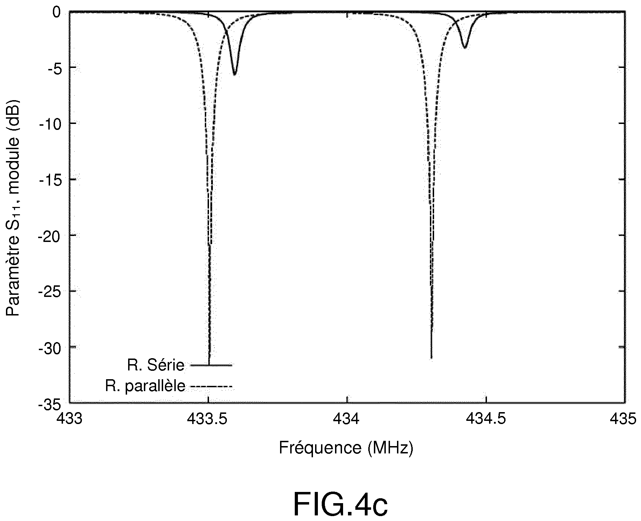

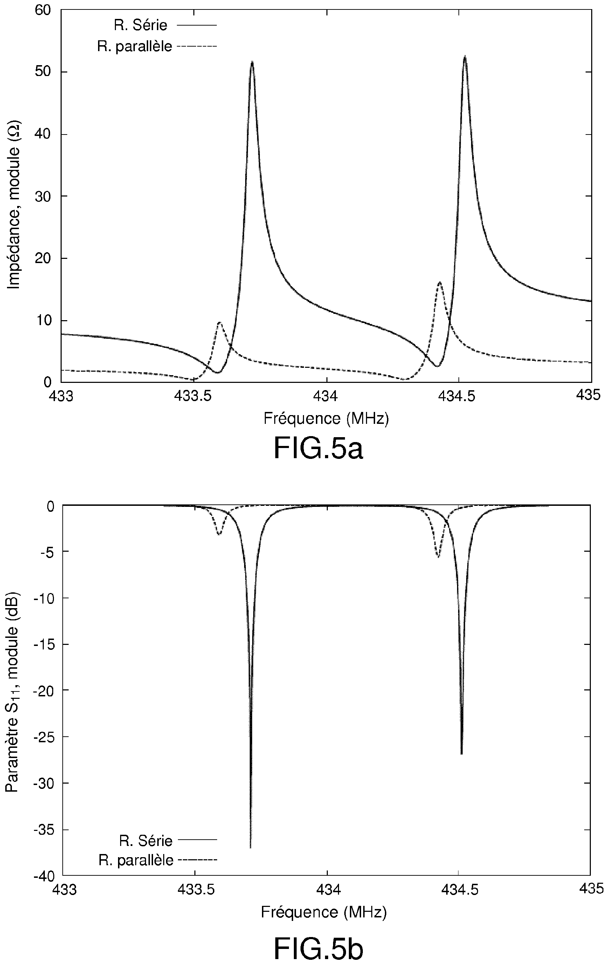

Les figures 4a-4c et 5a-5b montrent alors l'évolution de la réponse de deux résonateurs dont la fréquence de résonance est fixée à 433,5 et 434,3 MHz respectivement.

On note qu'effectivement, la réponse en coefficient de réflexion $S_{11}$ est maximale pour les résonateurs branchés en parallèle pour une capacité statique de 0,73 pF alors qu'elle s'avère optimisée pour des résonateurs branchés en série pour $C_0$=73pF.

Il ressort des figures 4a à 4c que les deux configurations présentent bien des réponses mais la dynamique est maximale pour des résonateurs en parallèle.

Il ressort des figures 5a et 5b que les deux configurations présentent bien des réponses mais la dynamique des résonateurs branchés en série est notablement plus marquée.

Bien que la capacité statique vue à l'anti-résonance par chaque résonateur soit bien égale à $C_0$/2, le Demandeur n'a pas constaté de différences majeures entre les couplages électromécaniques calculés pour les deux types de circuits.

On note que deux résonateurs optimisés pour fonctionner à 50 $\Omega$ à la résonance ne doivent pas être modifiés en termes de design et ce quelle que soit le mode de connexion, comme le montrent l'ensemble des figures 4a-4c et 5a-5b.

En effet, en dehors de ses résonance et anti-résonance, un résonateur SAW dipôle monomode se comporte comme une capacité simple et donc un court-circuit en régime RF. Du point de vue comportement en réflexion, le court-circuit et le circuit ouvert donne lieu à aucune absorption de signal (toute l'énergie incident est réfléchie).

Il est par ailleurs connu que la présence d'une résistance en série du circuit résonant peut affecter la qualité de la résonance. De même, l'existence d'une self-inductance liée à la connexion du résonateur vient rajouter de la complexité au circuit équivalent mais apporte également plus d'informations sur sa réponse effective une fois celui-ci encapsulé.

Un schéma complet inclut enfin une possible résistance en parallèle ou en série de la capacité statique représentant les courants de fuite dans le matériau (la langasite souffre particulièrement d'un tel défaut, ceci étant connu de l'homme de l'art). On montre que le fonctionnement sur l'anti-résonance permet de minimiser l'impact de la résistance de connexion en série sur le coefficient de qualité du pic d'anti-résonance.

Cet élément signifie que pour les matériaux à couplage électromécanique notablement élevé (soit supérieur au pour-cent), il est également préférable de favoriser l'anti-résonance, la résonance étant notoirement affectée par la présence d'une résistance de contact de l'ordre de 1 $\Omega$ et plus.

Pour une description exhaustive des résultats, on note qu'en mode « série » (résonateurs optimisés sur l'anti-résonance), le premier résonateur présente un couplage plus élevé que le second, la somme des couplages étant sensiblement égale au couplage de chaque résonateur pris de façon indépendante ($k_s^2$ est supposé identique pour chaque résonateur et fixé à 0,1% pour un Q de 10000, $C_0$=73,2 pF, cas proche du quartz).

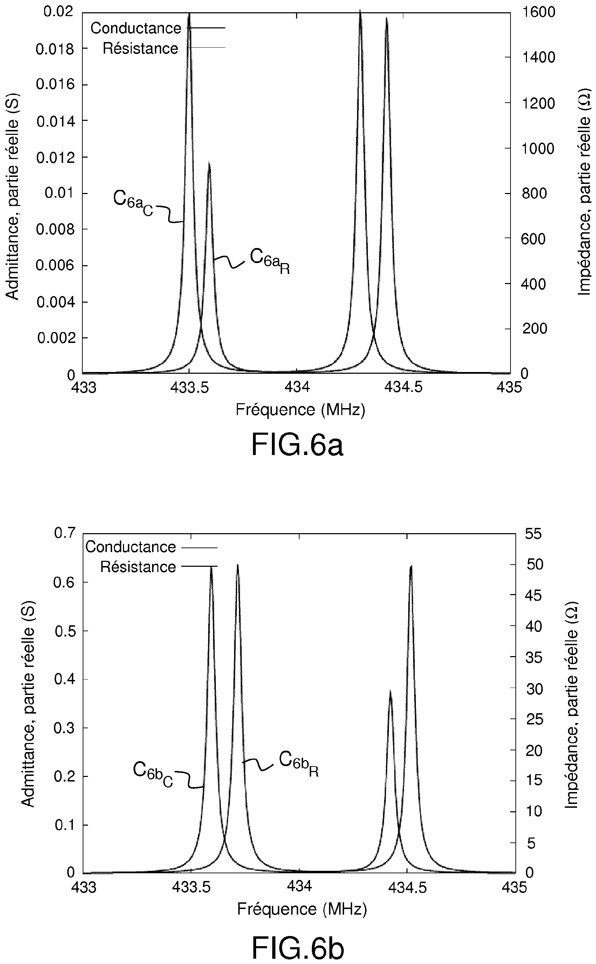

Les figures 6a et 6b caractérisent des couplages électromécaniques de chaque contribution pour les deux configurations de connexion : la figure 6a est relative à des résonateurs en parallèle : fonctionnement sur la résonance ; la figure 6b est relative à des résonateurs en série : fonctionnement sur l'anti-résonance. Les courbes C6a$_R$ et C6b$_R$ sont relatives à la résistance, les courbes C6a$_c$ et C6b$_c$ sont relatives à la conductance.

Le Demandeur a trouvé pour le résonateur à 433,7 MHz un couplage de 0,567‰ et de 0,432‰ pour celui à 434.4 MHz.

La situation optimisée en résonance ($k_s^2$ toujours fixé à 0,1% pour un Q de 10000, $C_0$=0,73 pF, cas proche du quartz) présente une configuration rigoureusement inversée.

On trouve alors pour les fréquences de résonance à 433,5 et 434,3 MHz des couplages de 0,433 et 0,566‰.

Il convient donc de travailler en amont de l'assemblage des résonateurs pour obtenir une réponse du circuit idéalement optimisée et équilibrée au niveau des contributions de chaque résonateur.

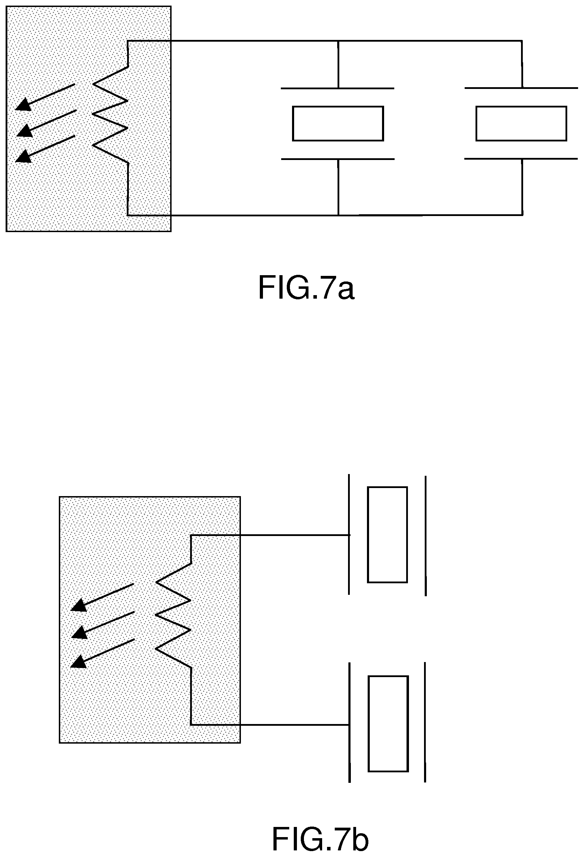

Les figures 7a et 7b illustrent respectivement la façon dont peuvent être agencés les résonateurs connectés en parallèle lorsque ceux-ci fonctionnent (sont interrogés) sur la résonance (configuration dite « classique ») et la connexion discutée ci-dessus, pour laquelle les résonateurs sont connectés en série et qui se prête particulièrement au cas où les résonateurs fonctionnent sur l'anti-résonance.

Ces figures mettent en évidence l'antenne permettant d'interroger les capteurs. Elle est représentée comme un quadripôle connecté sur sa résistance de rayonnement.

## Revendications

1. Résonateur à ondes élastiques de surface comprenant un matériau piézoélectrique destiné à la propagation des ondes élastiques de surface et au moins un transducteur inséré entre une paire de réflecteurs, ledit transducteur comprenant des peignes d'électrodes interdigitées et présentant un nombre Nc d'électrodes connectées à un point chaud et une ouverture acoustique W **caractérisé en ce que** le matériau piézoélectrique présente une permittivité relative supérieure à 15 F.m$^{-1}$, ledit transducteur présentant un produit Nc.W/fa supérieur à 100 $\mu$m.MHz$^{-1}$ avec fa la fréquence d'antirésonance dudit résonateur.

2. Résonateur à base de matériau piézoélectrique selon la revendication 1, **caractérisé en ce que** le matériau piézoélectrique est de la langasite, le produit Nc.W/fa étant compris entre 100 et 1000 $\mu$m.MHz$^{-1}$.

3. Résonateur à base de matériau piézoélectrique selon la revendication 1, **caractérisé en ce que** le matériau piézoélectrique est du tantalate de lithium LiTaO$_3$, le produit Nc.W/fa étant compris entre 100 et 1000 $\mu$m.MHz$^{-1}$.

4. Résonateur à base de matériau piézoélectrique selon la revendication 1, **caractérisé en ce que** le matériau piézoélectrique est du niobate de lithium, le produit Nc.W/fa étant compris entre 1400 et 3000 $\mu$m.MHz$^{-1}$.

5. Résonateur à base de matériau piézoélectrique selon l'une des revendications 1 à 4, **caractérisé en ce que** les électrodes sont à base de platine ou de titane ou de tantale, ou un mélange de certains des métaux précités.

6. Résonateur à base de matériau piézoélectrique selon l'une des revendications 1 à 5, **caractérisé en ce qu'**il comprend une couche de passivation pouvant être une couche d'alumine (Al$_2$O$_3$) ou d'oxyde de silicium ou de nitrure de silicium ou de nitrure d'aluminium.

7. Circuit comprenant au moins une impédance de charge et au moins un résonateur selon l'une des revendications 1 à 6, et présentant une réponse électrique traduite par un pic de coefficient de réflexion S$_{11}$ en fréquence **caractérisée par** une valeur minimum du paramètre S$_{11}$ au moins inférieure à - 10 dB, le pic d'antirésonance dudit résonateur étant adapté à l'impédance de la charge.

8. Circuit comprenant au moins deux résonateurs selon l'une des revendications 1 à 6, connectés en série.

9. Circuit selon la revendication 8, dans lequel lesdits résonateurs sont connectés à une antenne.

10. Capteur passif interrogeable à distance comprenant un circuit selon l'une des revendications 7 à 9.

11. Capteur de température différentiel passif interrogeable à distance comprenant deux résonateurs selon l'une des revendications 1 à 6.

12. Système d'interrogation d'un circuit selon l'une des revendications 7 à 9, ou d'un capteur selon l'une des revendications 10 ou 11, **caractérisé en ce qu'**il comprend des moyens d'interrogation fonctionnant dans une bande de fréquences situées entre 400 MHz et 450 MHz.

13. Système d'interrogation d'un circuit selon l'une des revendications 7 à 9, ou d'un capteur selon l'une des revendications 10 ou 11, **caractérisé en ce qu'**il comprend des moyens d'interrogation fonctionnant dans une bande de fréquences situées entre 900 MHz et 950 MHz.

14. Système d'interrogation d'un circuit selon l'une des revendications 7 à 9, ou d'un capteur selon l'une des revendications 10 ou 11, **caractérisé en ce qu'**il comprend des moyens d'interrogation fonctionnant dans une bande de fréquences situées entre 850 MHz et 900 MHz.

**Patentansprüche**

1. Resonator mit elastischen Oberflächenwellen, beinhaltend ein piezoelektrisches Material, welches zur Fortpflanzung der elastischen Oberflächenwellen bestimmt ist und mindestens einen Umformer, welcher zwischen einem Paar Reflektoren eingesetzt ist, wobei der Umformer interdigital angeordnete Elektrodenkämme beinhaltet und eine Anzahl Nc von mit einem heißen Punkt verbundenen Elektroden und eine akustische Öffnung W aufweist, **dadurch gekennzeichnet, dass** das piezoelektrische Material eine relative Permittivität über 15 F.m$^{-1}$ aufweist, wobei der Umformer ein Produkt Nc.W/fa über 100 gm.MHz$^{-1}$ aufweist, wobei fa die Antiresonanzfrequenz des Resonators ist.

2. Resonator, basierend auf einem piezoelektrischen Material nach Anspruch 1, **dadurch gekennzeichnet, dass** das piezoelektrische Material Langasit ist, wobei das Produkt Nc.W/fa zwischen 100 und 1.000 $\mu$m.MHz$^{-1}$ liegt.

3. Resonator, basierend auf einem piezoelektrischen Material nach Anspruch 1, **dadurch gekennzeichnet, dass** das piezoelektrische Material Lithiumtantalat LiTaO$_3$ ist, wobei das Produkt Nc.W/fa zwischen 100 und 1.000 $\mu$m.MHz$^{-1}$ liegt.

4. Resonator, basierend auf einem piezoelektrischen Material nach Anspruch 1, **dadurch gekennzeichnet, dass** das piezoelektrische Material Lithiumniobat ist, wobei das Produkt Nc.W/fa zwischen 1.400 und 3.000 $\mu$m.MHz$^{-1}$ liegt.

5. Resonator, basierend auf einem piezoelektrischen Material nach einem der Ansprüche 1 bis 4, **dadurch gekennzeichnet, dass** die Elektroden auf Platin oder Titan oder Tantal oder auf einer Mischung bestimmter der vorgenannten Metalle basieren.

6. Resonator, basierend auf einem piezoelektrischen Material nach einem der Ansprüche 1 bis 5, **dadurch gekennzeichnet, dass** er eine Passivierungsschicht beinhaltet, welche eine Schicht aus Aluminiumoxid (Al$_2$O$_3$) oder aus Siliziumoxid oder aus Siliziumnitrid oder aus Aluminiumnitrid sein kann.

7. Schaltkreis, beinhaltend mindestens eine Ladungsimpedanz und mindestens einen Resonator nach einem der Ansprüche 1 bis 6, und welcher eine elektrische Reaktion aufweist, welche sich durch einen Peak des Frequenz-Reflexionskoeffizienten S$_{11}$ äußert, **gekennzeichnet durch** einen Minimalwert des Parameters S$_{11}$ von mindestens unter - 10 dB, wobei der Antiresonanz-Peak des Resonators an die Impedanz der Ladung angepasst ist.

8. Schaltkreis, beinhaltend mindestens zwei in Reihe verbundene Resonatoren nach einem der Ansprüche 1 bis 6.

9. Schaltkreis nach Anspruch 8, bei welchem die Resonatoren mit einer Antenne verbunden sind.

10. Femabfragbarer, passiver Sensor, beinhaltend einen Schaltkreis nach einem der Ansprüche 7 bis 9.

11. Fernabfragbarer, passiver Differentialtemperatursensor, beinhaltend zwei Resonatoren nach einem der Ansprüche 1 bis 6.

12. Abfragesystem eines Schaltkreises nach einem der Ansprüche 7 bis 9, oder eines Sensors nach einem der Ansprüche 10 oder 11, **dadurch gekennzeichnet, dass** es Abfragemittel beinhaltet, welche in einem Frequenzband zwischen 400 MHz und 450 MHz arbeiten.

13. Abfragesystem eines Schaltkreises nach einem der Ansprüche 7 bis 9, oder eines Sensors nach einem der Ansprüche 10 oder 11, **dadurch gekennzeichnet, dass** es Abfragemittel beinhaltet, welche in einem Frequenzband zwischen 900 MHz und 950 MHz arbeiten.

14. Abfragesystem eines Schaltkreises nach einem der Ansprüche 7 bis 9, oder eines Sensors nach einem der Ansprüche 10 oder 11, **dadurch gekennzeichnet, dass** es Abfragemittel beinhaltet, welche in einem Frequenzband zwischen 850 MHz und 900 MHz arbeiten.

**Claims**

1. Surface elastic wave resonator comprising a piezoelectric material intended to propagate the surface elastic waves and at least one transducer inserted between a pair of reflectors, said transducer comprising combs of interdigitated electrodes and having a number Nc of electrodes that are connected to a hot spot and an acoustic aperture W, **characterized in that** the relative permittivity of the piezoelectric material is greater than 15 F.m$^{-1}$, said transducer having a product Nc.W/fa being greater than 100 $\mu$m.MHz$^{-1}$, where fa is the antiresonance frequency of said resonator.

2. Resonator based on piezoelectric material according to Claim 1, **characterized in that** the piezoelectric material is langasite, the product Nc.W/fa being in the range from 100 to 1000 $\mu$m.MHz$^{-1}$.

3. Resonator based on piezoelectric material according to Claim 1, **characterized in that** the piezoelectric material is lithium tantalate LiTaO$_3$, the product Nc.W/fa being in the range from 100 to 1000 $\mu$m.MHz$^{-1}$.

4. Resonator based on piezoelectric material according to Claim 1, **characterized in that** the piezoelectric material is lithium niobate, the product Nc.W/fa being in the range from 1400 to 3000 $\mu$m.MHz$^{-1}$.

5. Resonator based on piezoelectric material according to any one of Claims 1 to 4, **characterized in that** the electrodes are based on platinum or on titanium or on tantalum, or a mixture of some of the aforementioned metals.

6. Resonator based on piezoelectric material according to any one of Claims 1 to 5, **characterized in that** it comprises a passivation layer that may be a layer of alumina (Al$_2$O$_3$) or of silicon oxide or of silicon nitride or of aluminum nitride.

7. Circuit comprising at least one load impedance and at least one resonator according to any one of Claims 1 to 6 and having an electrical response manifesting as a peak in the coefficient of reflection S$_{11}$ at a frequency **characterized by** a minimum value of the parameter S$_{11}$ that is at least lower than -10 dB, the antiresonance peak of said resonator being matched to the impedance of the load.

8. Circuit comprising at least two resonators according to any one of Claims 1 to 6, connected in series.

9. Circuit according to Claim 8, in which said resonators are connected to an antenna.

10. Remotely interrogable passive sensor comprising a circuit according to any one of Claims 7 to 9.

11. Remotely interrogable passive differential temperature sensor comprising two resonators according to any one of Claims 1 to 6.

12. System for interrogating a circuit according to any one of Claims 7 to 9, or for interrogating a sensor according to any one of Claims 10 or 11, **characterized in that** it comprises interrogation means operating in a band of frequencies located between 400 MHz and 450 MHz.

13. System for interrogating a circuit according to any one of Claims 7 to 9, or for interrogating a sensor according to any one of Claims 10 or 11, **characterized in that** it comprises interrogation means operating in a band of frequencies located between 900 MHz and 950 MHz.

14. System for interrogating a circuit according to any one of Claims 7 to 9, or for interrogating a sensor according to any one of Claims 10 or 11, **characterized in that** it comprises interrogation means operating in a band of frequencies located between 850 MHz and 900 MHz.

FIG.1a

FIG.1b

FIG.2

FIG.3a

FIG.3b

FIG.4a

FIG.4b

FIG.4c

FIG.5a

FIG.5b

FIG.6a

FIG.6b

FIG.7a

FIG.7b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20090230816 A1
- FR 2951335 A1
- EP 2980550 A
- WO 2011020888 A1

**Littérature non-brevet citée dans la description**

- **ROYER, E. DIEULESAINT.** Ondes acoustiques dans les solides. 1998
- **MORGAN, DAVID.** Surface acoustic wave filters: With applications to electronic communications and signal processing. Academic Press, 2010